# EUROPEAN PATENT SPECIFICATION

(11) **EP 2 070 451 B1**
(45) Date of publication and mention of the grant of the patent: **16.09.2015**
(21) Application number: 08169019.0
(22) Date of filing: 13.11.2008
(51) Int. Cl.: A47J 41/00, A47J 27/21, H01L 35/00

(54) **Portable cold and hot water supply device**
Tragbare Vorrichtung zur Abgabe von kaltem und heißem Wasser
Dispositif portable d'alimentation en eau chaude et froide

(30) Priority: 14.12.2007 TW 96147932; 01.07.2008 TW 97124685
(43) Date of publication of application: 17.06.2009
(73) Proprietor: Industrial Technology Research Institute, Hsinchu 31040 (TW)
(72) Inventor: Li, Hsin-Hung, 404, Taichung City (TW); Hsieh, Jung-Ya, 406, Taichung City (TW); Ting, Chun-Chien, 636, Yunlin Country (TW); Nien, Yung-Feng, 408, Taichung City (TW)
(74) Representative: Fuchs Patentanwälte Partnerschaft mbB

(56) References cited:
- DE-A1- 3 718 715
- FR-A- 2 759 774
- JP-A- 11 094 423
- US-A1- 2003 070 430

## Description

### BACKGROUND OF THE INVENTION

### Field of the Invention

The invention relates to portable cold and hot water supply devices, and more particularly to portable cold and hot water supply devices employing thermoelectric semiconductor chips to heat and cool water.

### Description of the Related Art

A conventional portable thermos often comprises a bottle body and a cap. The bottle body comprises only a storage chamber and is constructed with a thermal insulation structure. For example, the bottle body may comprise two walls. A vacuum process is performed between the walls or heat-insulation material is filled therebetween, stopping heat transfer.

The bottle body of the conventional portable thermos can only provide a limited thermal insulation effect within a specific period of time, although constructed with the thermal insulation structure. Namely, the thermal insulation effect provided for a fluid received in the bottle body of the conventional portable thermos progressively deteriorates as time lapses or the cap is opened. Moreover, the conventional portable thermos provides only a single thermal insulation mode, such as a hot-water or icy-water thermal insulation mode, whenever accommodating a fluid. Accordingly, the conventional portable thermos cannot provide functions of arbitrary temperature adjustment for the fluid. Additionally, the conventional portable thermos cannot provide functions of temperature display, causing inconvenience in usage.

Moreover, a conventional immersion-heater thermos utilizes an immersion heater to heat a fluid received therein. The immersion heater, however, requires a high operational voltage and consumes enormous electric power. Specifically, the immersion heater requires an operational voltage of at least 12 volts. Namely, the immersion heater can hardly be actuated by dry batteries, thereby causing difficulties of application. Additionally, as the immersion heater consumes enormous electric power, power shortage easily occurs. Furthermore, as the immersion-heater thermos provides only a heating function, usage of the immersion-heater thermos is limited. Moreover, the immersion-heater thermos cannot display the temperature of the fluid although providing a function of heating-temperature control which is awkward.

Regarding a conventional non-portable household drinking fountain, a thermoelectric semiconductor chip is employed to selectively cool water received therein. Here, an operational voltage required by the thermoelectric semiconductor chip and electric power consumed thereby is minimized. Nevertheless, when the drinking fountain contains a large amount of water, the cooling speed of the water is relatively slow. Additionally, a low operational voltage is not required by household appliances because sockets with an operational voltage of 110 or 220 volts are often provided in dwelling houses. Additionally, the conventional household drinking fountain cannot be carried by users.

US 2003/070430 discloses a water heater system with two separate compartments separated by a one-way valve.

Hence, there is a need for portable cold and hot water supply devices capable of arbitrarily adjusting the temperature of a fluid received therein as required with reduced power consumption.

### BRIEF SUMMARY OF THE INVENTION

A detailed description is given in the following embodiments with reference to the accompanying drawings.

The present portable cold and hot water supply devices employ thermoelectric semiconductor chips. According to the Poltier effect, thermoelectric semiconductor chips create an exothermic or endothermic operation when the direction of an electric current applied therein varies, thereby heating or cooling a fluid received in the portable cold and hot water supply devices. Additionally, as the thermoelectric semiconductor chips consume a small amount of electric power, overall power consumption of the portable cold and hot water supply devices is reduced.

The present portable cold and hot water supply device comprises a first chamber and a second chamber. The first and second chambers receive a fluid. When the amount of the fluid in the second chamber is insufficient, the fluid can be supplemented into the second chamber from the first chamber. The second chamber can arbitrarily adjust the temperature of the fluid received therein as required. Namely, because only the fluid received in the second chamber is heated or cooled, the power consumption of the portable cold and hot water supply device is reduced.

An exemplary embodiment of the invention provides a portable cold and hot water supply device comprising a container body, a controller, a power supply device, and a thermoelectric semiconductor chip. The container body comprises a fluid inlet, a fluid outlet, a first chamber, a second chamber, and a valve sphere. The first chamber connects to the fluid inlet and comprises a circular connecting hole. The second chamber connects to the fluid outlet and connects to the first chamber via the circular connecting hole. The diameter of the valve sphere exceeds that of the circular connecting hole. The valve sphere is rotatably disposed between the first and second chambers and is detachably engaged in the circular connecting hole, controlling connection between the first and second chambers. The power supply device is electrically connected to the controller. The thermoelectric semiconductor chip abuts the second chamber of the container body and is electrically connected to the power supply device.

The volume of the second chamber is less than that of the first chamber.

The portable cold and hot water supply device further comprises a temperature sensor connected to the second chamber of the container body and electrically connected to the controller.

The portable cold and hot water supply device further comprises a fan adjacent to the thermoelectric semiconductor chip and electrically connected to the power supply device.

The portable cold and hot water supply device further comprises a base connected to the container body and covering the thermoelectric semiconductor chip and fan.

The base comprises at least one vent disposed around the fan.

The portable cold and hot water supply device further comprises a display panel electrically connected to the controller and power supply device.

The portable cold and hot water supply device further comprises an operation interface electrically connected to the controller and comprising a power switching key, a temperature-raising key, a temperature-lowering key, and an indicator light.

Moreover, the valve sphere may be replaced by an electromagnetic valve.

### BRIEF DESCRIPTION OF THE DRAWINGS

The invention can be more fully understood by reading the subsequent detailed description and examples with references made to the accompanying drawings, wherein:
FIG. 1 is a schematic perspective view of a portable cold and hot water supply device of a first embodiment of the invention;
FIG. 2 is a schematic cross section of the portable cold and hot water supply device of the first embodiment of the invention;
FIG. 3 is a schematic cross section of a portable cold and hot water supply device of a second embodiment of the invention;
FIG. 4 is a schematic perspective view of a portable cold and hot water supply device of the second embodiment of the invention; and
FIG. 5 is a flowchart showing control of the fluid temperature of the portable cold and hot water supply device of the invention.

### DETAILED DESCRIPTION OF THE INVENTION

The following description is of the best-contemplated mode of carrying out the invention. This description is made for the purpose of illustrating the general principles of the invention and should not be taken in a limiting sense. The scope of the invention is best determined by reference to the appended claims.

### First embodiment

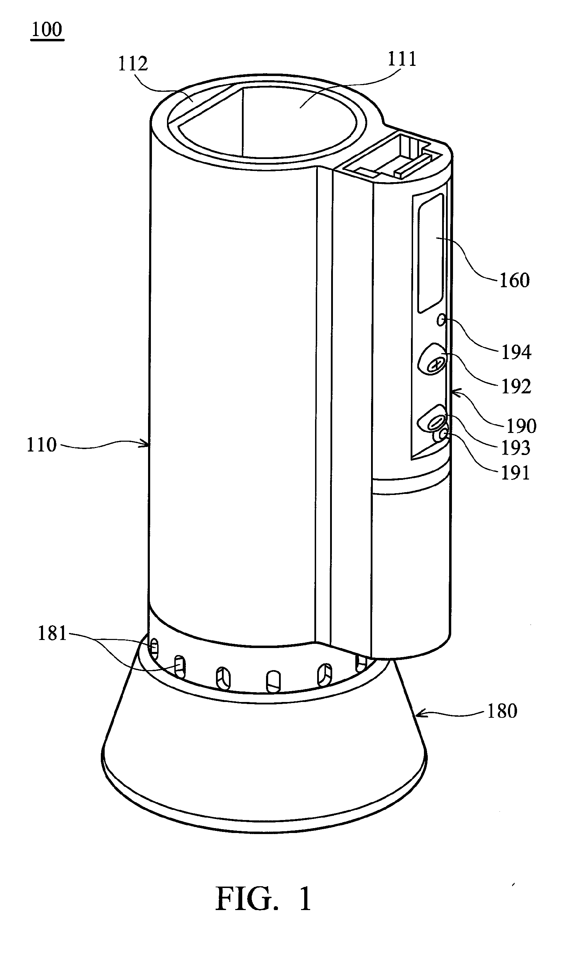

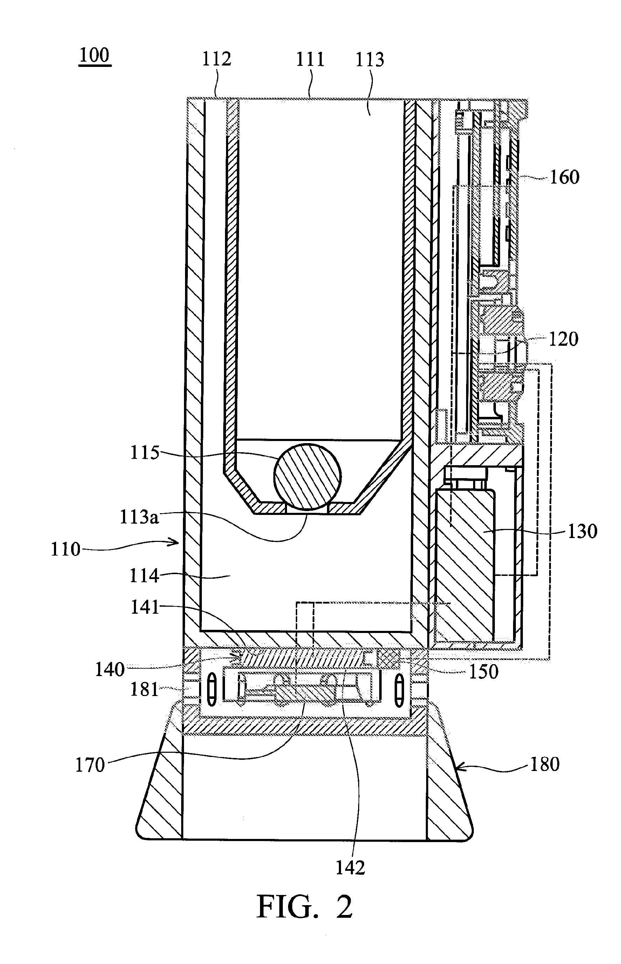

Referring to FIG. 1 and FIG. 2, a portable cold and hot water supply device 100 comprises a container body 110, a controller 120, a power supply device 130, a thermoelectric semiconductor chip 140, a temperature sensor 150, a display panel 160, a fan 170, a base 180, and an operation interface 190.

As shown in FIG. 2, the container body 110 comprises a fluid inlet 111, a fluid outlet 112, a first chamber 113, a second chamber 114, and a valve sphere 115. The first chamber 113 connects to the fluid inlet 111. The second chamber 114 connects to the fluid outlet 112. The valve sphere 115 is disposed between the first chamber 113 and the second chamber 114, controlling connection therebetween. Namely, whether the first chamber 113 connects to the second chamber 114 or not is controlled by the valve sphere 115. In this embodiment, the valve sphere 115 is rotatably disposed between the first chamber 113 and the second chamber 114. Specifically, the first chamber 113 comprises a circular connecting hole 113a formed on a wall thereof. The first chamber 113 connects to the second chamber 114 via the circular connecting hole 113a and the valve sphere 115 is detachably engaged in the circular connecting hole 113a. Additionally, the diameter of the valve sphere 115 exceeds that of the circular connecting hole 113a. Accordingly, when the valve sphere 115 is engaged in the circular connecting hole 113a, the circular connecting hole 113a is completely covered thereby, disconnecting the first chamber 113 from the second chamber 114. Moreover, in this embodiment, the volume of the second chamber 114 is less than that of the first chamber 113.

The controller 120 is disposed on the container body 110.

The power supply device 130 is disposed on the container body 110 and is electrically connected to the controller 120. In this embodiment, the power supply device 130 comprises a cell.

The thermoelectric semiconductor chip 140 abuts the second chamber 114 of the container body 110 and is electrically connected to the power supply device 130.

The temperature sensor 150 is connected to the second chamber 114 of the container body 110 and is electrically connected to the controller 120.

The display panel 160 is disposed on the container body 110 and is electrically connected to the controller 120 and power supply device 130.

The fan 170 is adjacent to the thermoelectric semiconductor chip 140 and is electrically connected to the power supply device 130.

The base 180 is connected to the second chamber 114 of the container body 110 and covers the thermoelectric semiconductor chip 140 and fan 170. Moreover, the base 180 comprises a plurality of vents 181 disposed around the fan 170.

As shown in FIG. 1, the operation interface 190 is adjacent to the display panel 160 and is electrically connected to the controller 120. Specifically, the operation interface 190 comprises a power switching key 191, a temperature-raising key 192, a temperature-lowering key 193, and an indicator light 194.

The following description is directed to operation of the portable cold and hot water supply device 100.

When the portable cold and hot water supply device 100 is in an upright mode (as shown in FIG. 1 and FIG. 2), the circular connecting hole 113a is completely covered by the valve sphere 115, thus disconnecting the first chamber 113 from the second chamber 114. Namely, when the portable cold and hot water supply device 100 is in the upright mode, a fluid received in the first chamber 113 cannot connect to that received in the second chamber 114. When wanting to know the temperature of the fluid received in the second chamber 114, an operator can press the power switching key 191 of the operation interface 190. At this point, the temperature sensor 150 connected to the second chamber 114 detects the temperature of the fluid received therein by thermal conduction and transmits detected temperature readings of the fluid to the controller 120. The detected temperature readings of the fluid can further be displayed on the display panel 160.

When adjusting the temperature of the fluid received in the second chamber 114, the operator can input a desired fluid temperature to the controller 120 by pressing the temperature-raising key 192 or temperature-lowering key 193. Here, the temperature of the fluid received in the second chamber 114 and the desired fluid temperature are simultaneously displayed on the display panel 160, and the indicator light 194 irradiates to show that temperature adjustment and the operation interface 190 is in operation. At this point, the controller 120 outputs a signal to drive the power supply device 130 to supply a current to the thermoelectric semiconductor chip 140, heating or cooling the fluid received in the second chamber 114. For example, when the desired fluid temperature set by the operator exceeds the temperature of the fluid received in the second chamber 114, the controller 120 drives the power supply device 130 to supply a current to the thermoelectric semiconductor chip 140 in a current direction, enabling a surface 141, abutting the second chamber 114, of the thermoelectric semiconductor chip 140 to radiate heat, and further heating the fluid received in the second chamber 114. At the same time, the temperature sensor 150 persistently detects the temperature of the fluid received in the second chamber 114 and transmits the detected temperature readings to the controller 120 and display panel 160. When the actual temperature, detected by the temperature sensor 150, of the fluid accords with the desired fluid temperature, the controller 120 stops the power supply device 130 from supplying the current to the thermoelectric semiconductor chip 140. On the other hand, when the desired fluid temperature set by the operator is less than the temperature of the fluid received in the second chamber 114, the controller 120 drives the power supply device 130 to supply a current to the thermoelectric semiconductor chip 140 in an opposite current direction, enabling the surface 141, abutting the second chamber 114, of the thermoelectric semiconductor chip 140 to cool down, and further cooling the fluid received in the second chamber 114. At this point, an opposite surface 142 of the thermoelectric semiconductor chip 140 radiates heat due to heat transfer. The heat generated on the opposite surface 142 can then be transmitted to the exterior of the portable cold and hot water supply device 100 via the vents 181 of the base 180 by operation of the fan 170. Similarly, the temperature sensor 150 persistently detects the temperature of the fluid received in the second chamber 114 and transmits the detected temperature readings to the controller 120 and display panel 160. When the actual temperature, detected by the temperature sensor 150, of the fluid accords with the desired fluid temperature, the controller 120 stops the power supply device 130 from supplying the current to the thermoelectric semiconductor chip 140.

Additionally, the operation interface 190 may be simplified to a three-step power switching key providing operations of heating, shutdown, and cooling. The three-step power switching key is electrically connected to the controller 120. The operator can obtain the temperature of the fluid received in the second chamber 114. When adjusting the temperature of the fluid received in the second chamber 114, the operator can operate the three-step power switching key of the operation interface 190 to heat or cool the fluid received in the second chamber 114. When the temperature reading, of the fluid received in the second chamber 114, displayed on the display panel 160 accords with the desired temperature set by the operator, the operator can switch the three-step power switching key to a shutdown mode. At this point, the controller 120 stops the power supply device 130 from supplying the current to the thermoelectric semiconductor chip 140.

In another aspect, when taking the fluid received in the second chamber 114, the operator can tilt the container body 110, enabling the fluid to flow out of the second chamber 114 via the fluid outlet 112. At this point, the tilted container body 110 forces the valve sphere 115 to roll in the first chamber 113 by gravity, thereby separating the valve sphere 115 from the circular connecting hole 113a of the first chamber 113. Accordingly, the fluid can flow from the first chamber 113 into the second chamber 114 via the circular connecting hole 113a, replenishing the second chamber 114 with the fluid.

In another aspect, when supplementing the fluid to the first chamber 113, the operator can simply put the container body 110 upright, forcing the valve sphere 115 to again roll by gravity to engage the circular connecting hole 113a. The operator can then supplement the fluid to the first chamber 113 via the fluid inlet 111.

Additionally, the power supply device 130 is not limited to a cell. For example, the power supply device 130 may be a solar-energy power generation device or a bicycle power generation device.

### Second embodiment

Elements corresponding to those in the first embodiment share the same reference numerals.

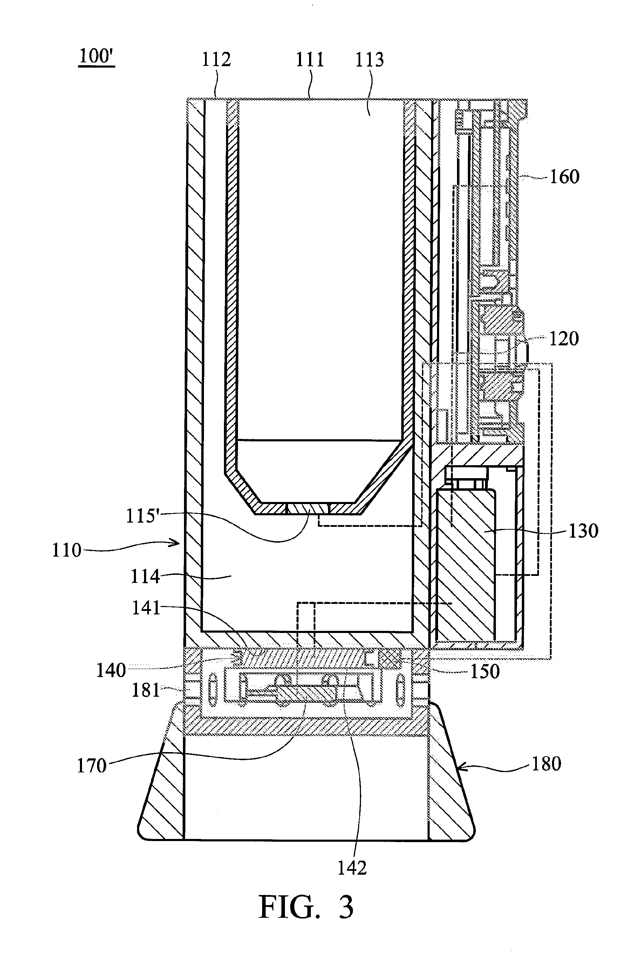

This embodiment differs from the first embodiment in that the valve sphere 115 and circular connecting hole 113a of the first embodiment are replaced by an electromagnetic valve 115'. As shown in FIG. 3, in a portable cold and hot water supply device 100', the electromagnetic valve 115' is also disposed between the first chamber 113 and the second chamber 114. In this embodiment, the electromagnetic valve 115' is electrically connected to the controller 120. Specifically, open and closed operations of the electromagnetic valve 115' are controlled by an operation interface 190', thereby controlling connection between the first chamber 113 and the second chamber 114.

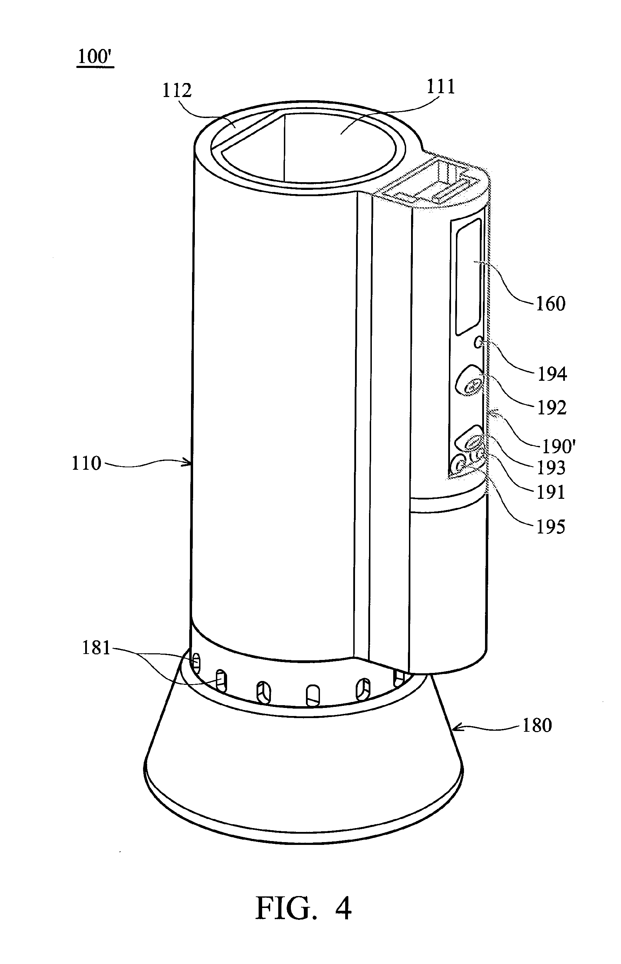

Moreover, as shown in FIG. 4, the operation interface 190' comprises a power switching key 191, a temperature-raising key 192, a temperature-lowering key 193, an indicator light 194, and an electromagnetic valve switching key 195. Similarly, the operation interface 190' is electrically connected to the controller 120.

As shown in FIG. 3 and FIG. 4, when adjusting the temperature of the fluid received in the second chamber 114, an operator can input a desired fluid temperature to the controller 120 by pressing the temperature-raising key 192 or temperature-lowering key 193. Here, the temperature of the fluid received in the second chamber 114 and the desired fluid temperature are simultaneously displayed on the display panel 160, and the indicator light 194 irradiates to show that temperature adjustment and the operation interface 190' is in operation. At this point, the controller 120 outputs a signal to drive the power supply device 130 to supply a current to the thermoelectric semiconductor chip 140, heating or cooling the fluid received in the second chamber 114. For example, when the desired fluid temperature set by the operator exceeds the temperature of the fluid received in the second chamber 114, the controller 120 drives the power supply device 130 to supply a current to the thermoelectric semiconductor chip 140 in a current direction, enabling a surface 141, abutting the second chamber 114, of the thermoelectric semiconductor chip 140 to radiate heat, and further heating the fluid received in the second chamber 114. At the same time, the temperature sensor 150 persistently detects the temperature of the fluid received in the second chamber 114 and transmits the detected temperature readings to the controller 120 and display panel 160. When the actual temperature, detected by the temperature sensor 150, of the fluid accords with the desired fluid temperature, the controller 120 stops the power supply device 130 from supplying the current to the thermoelectric semiconductor chip 140. On the other hand, when the desired fluid temperature set by the operator is less than the temperature of the fluid received in the second chamber 114, the controller 120 drives the power supply device 130 to supply a current to the thermoelectric semiconductor chip 140 in an opposite current direction, enabling the surface 141, abutting the second chamber 114, of the thermoelectric semiconductor chip 140 to cool down, and further cooling the fluid received in the second chamber 114. At this point, an opposite surface 142 of the thermoelectric semiconductor chip 140 radiates heat due to heat transfer. The heat generated on the opposite surface 142 can then be transmitted to the exterior of the portable cold and hot water supply device 100' via the vents 181 of the base 180 by operation of the fan 170. Similarly, the temperature sensor 150 persistently detects the temperature of the fluid received in the second chamber 114 and transmits the detected temperature readings to the controller 120 and display panel 160. When the actual temperature, detected by the temperature sensor 150, of the fluid accords with the desired fluid temperature, the controller 120 stops the power supply device 130 from supplying the current to the thermoelectric semiconductor chip 140.

Additionally, no matter if the portable cold and hot water supply device 100' is in an upright mode or a tilted mode, the open and closed operations of the electromagnetic valve 115' can be controlled by the electromagnetic valve switching key 195 of the operation interface 190'. Specifically, when the electromagnetic valve 115' is closed, the fluid received in the first chamber 113 cannot connect to that received in the second chamber 114 no matter if the portable cold and hot water supply device 100' is upright or tilted. In another aspect, when the fluid is supplemented to the second chamber 114, the electromagnetic valve 115' can be opened by pressing of the electromagnetic valve switching key 195. At this point, the fluid can flow from the first chamber 113 to the second chamber 114 via the electromagnetic valve 115', thereby replenishing the second chamber 114 with the fluid. After the fluid is supplemented to the second chamber 114, the electromagnetic valve 115' can be closed by pressing of the electromagnetic valve switching key 195 again, disconnecting the fluid received in the first chamber 113 from that received in the second chamber 114.

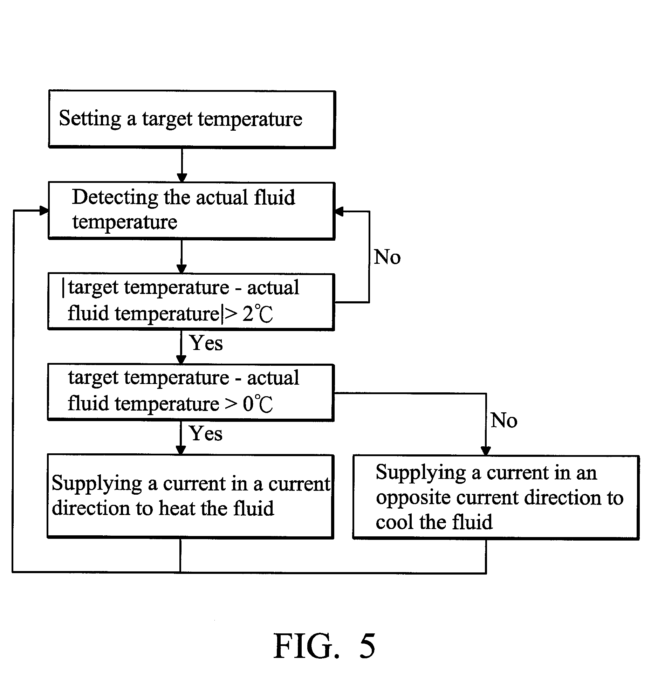

FIG. 5 is a flowchart showing control of the fluid temperature of the portable cold and hot water supply device of the invention. When adjusting the temperature of the fluid received in the portable cold and hot water supply device, the operator can set a target temperature. The temperature sensor connected to the second chamber detects the temperature of the fluid and transmits the detected temperature readings to the controller. The controller determines a temperature difference between the target temperature set by the operator and the actual fluid temperature detected by the temperature sensor. The controller then judges whether the temperature difference exceeds a predetermined temperature difference, such as 2°C. When the temperature difference is within the predetermined temperature difference (2°C), the thermoelectric semiconductor chip is not actuated and the temperature sensor persistently detects the temperature of the fluid. On the other hand, when the temperature difference exceeds the predetermined temperature difference (2°C), the controller further determines whether the result of the target temperature minus the actual fluid temperature is a plus value or a minus value. Here, a plus value indicates that the target temperature exceeds the actual fluid temperature, such that the controller drives the power supply device to supply a current to the thermoelectric semiconductor chip in a current direction, heating the fluid. On the contrary, a minus value indicates that the target temperature is less than the actual fluid temperature, such that the controller drives the power supply device to supply a current to the thermoelectric semiconductor chip in an opposite current direction, cooling the fluid. The aforementioned operation is repeatedly performed until the temperature difference between the target temperature and the actual fluid temperature is within the predetermined temperature difference.

In conclusion, in the disclosed portable cold and hot water supply devices, the temperature of the fluid received therein can be arbitrarily adjusted as required. Namely, the fluid can be arbitrarily heated or cooled. Additionally, because thermoelectric semiconductor chips heat or cool only the fluid received in the second chambers (smaller chambers) of the portable cold and hot water supply devices, overall power consumption thereof can be reduced. Moreover, the portable cold and hot water supply devices further provide the following advantages. The portable cold and hot water supply devices require a low operational voltage (such as 1.5 volts), such that they can be driven by a common dry battery. In addition, the portable cold and hot water supply devices consume less power and provide functions of temperature display.

While the invention has been described by way of example and in terms of preferred embodiment, it is to be understood that the invention is not limited thereto. To the contrary, it is intended to cover various modifications within the scope of the appended claims.

## Claims

1. A portable cold and hot water supply device (100), comprising a container body (110), a controller (120), a power supply device (130) and a thermoelectric semiconductor chip (140), wherein:
the container body (110) comprises a fluid inlet (111), a fluid outlet (112), a first chamber (113) connected to the fluid inlet (111) and comprising a circular connecting hole (113a), a second chamber (114) connected to the fluid outlet (112), and a valve sphere (115), wherein the first chamber (113) is received in the second chamber (114), the second chamber (114) connects to the first chamber (113) via the circular connecting hole (113a) of the first chamber (113), the diameter of the valve sphere (115) exceeds that of the circular connecting hole (113a) of the first chamber (113), and the valve sphere (115) is rotatably disposed between the first and second chambers (113 and 114) to be detachably engaged in the circular connecting hole (113a) of the first chamber (113) for controlling connection between the first and second chambers (113 and 114); the power supply device (130) is electrically connected to the controller (120); and the thermoelectric semiconductor chip (140) is abutted the second chamber (114) of the container body (110) and is electrically connected to the power supply device (130), wherein the controller (120) drives the power supply device (130) to energize the thermoelectric semiconductor chip (140) for heating the fluid received in the second chamber (114) when a temperature of a fluid received in the second chamber (114) is less than a desired temperature from the controller (120), and the temperature of the fluid received in the second chamber (114) is cooled via the thermoelectric semiconductor chip (140) by expelling heat generating from the thermoelectric semiconductor chip (140) when the temperature of the fluid received in the second chamber (114) is greater than the desired temperature from the controller (120).

2. The portable cold and hot water supply device (100) as claimed in claim 1, wherein the volume of the second chamber (114) is less than that of the first chamber (113).

3. The portable cold and hot water supply device (100) as claimed in claim 1, further comprising a temperature sensor connected to the second chamber (114) of the container body (110) and electrically connected to the controller (120).

4. The portable cold and hot water supply device (100) as claimed in claim 1, further comprising a fan (170) adjacent to the thermoelectric semiconductor chip (140) and electrically connected to the power supply device (130).

5. The portable cold and hot water supply device (100) as claimed in claim 4, further comprising a base (180) connected to the container body (110) and covering the thermoelectric semiconductor chip (140) and the fan (170).

6. The portable cold and hot water supply device (100) as claimed in claim 5, wherein the base (180) comprises at least one vent (181) disposed around the fan (170).

7. The portable cold and hot water supply device (100) as claimed in claim 1, further comprising a display panel (160) electrically connected to the controller(120) and the power supply device (130).

8. The portable cold and hot water supply device (100) as claimed in claim 1, further comprising an operation interface (190) electrically connected to the controller (120) and comprising a power switching key (191), a temperature-raising key (192), a temperature-lowering key (193), and an indicator light (194).

9. A portable cold and hot water supply device (100'), comprising a controller (120), a container body (110), a power supply device (130) and a thermoelectric semiconductor chip (140), wherein:
the container body (110) comprises a fluid inlet (111), a fluid outlet (112), a first chamber (113) connected to the fluid inlet (111), a second chamber (114) connected to the fluid outlet (112), and an electromagnetic valve (115') disposed between the first and second chambers (113 and 114) and electrically connected to the controller (120) for controlling connection between the first and second chambers (113 and 114), wherein the first chamber (113) is received in the second chamber (114), the power supply device (130) is electrically connected to the controller (120), and the thermoelectric semiconductor chip (140) abutted the second chamber (114) of the container body (110) is electrically connected to the power supply device (130), wherein the controller (120) drives the power supply device (130) to energize the thermoelectric semiconductor chip (140) for heating the fluid received in the second chamber (114) when a temperature of a fluid received in the second chamber (114) is less than a desired temperature from the controller (120), and the temperature of the fluid received in the second chamber (114) is cooled via the thermoelectric semiconductor chip (140) by expelling heat generating from the thermoelectric semiconductor chip (140) when the temperature of the fluid received in the second chamber (114) is greater than the desired temperature from the controller (120).

10. The portable cold and hot water supply device (100') as claimed in claim 9, wherein the volume of the second chamber (114) is less than that of the first chamber (113).

11. The portable cold and hot water supply device (100') as claimed in claim 9, further comprising a temperature sensor connected to the second chamber (114) of the container body (110) and electrically connected to the controller (120).

12. The portable cold and hot water supply device (100') as claimed in claim 9, further comprising a fan (170) adjacent to the thermoelectric semiconductor chip (140) and electrically connected to the power supply device (130).

13. The portable cold and hot water supply device (100') as claimed in claim 12, further comprising a base (180) connected to the container body (110) and covering the thermoelectric semiconductor chip (140) and the fan (170).

14. The portable cold and hot water supply device (100') as claimed in claim 13, wherein the base (180) comprises at least one vent (181) disposed around the fan (170).

15. The portable cold and hot water supply device (100') as claimed in claim 9, further comprising a display panel (160) electrically connected to the controller (120) and the power supply device (130).

16. The portable cold and hot water supply device (100') as claimed in claim 9, further comprising an operation interface (190') electrically connected to the controller (120) and comprising a power switching key (191), a temperature-raising key (192), a temperature-lowering key (193), and an indicator light (194).

## Patentansprüche

1. Tragbare Vorrichtung (100) zum Abgeben von kaltem und heißem Wasser, umfassend einen Containerkörper (110), eine Steuereinheit (120), eine Strombereitstellungseinrichtung (130) und einen thermoelektrischen Halbleiterchip (140), wobei
der Containerkörper (110) einen Fluideingang (111), einen Fluidausgang (112), eine erste Kammer (113), die mit dem Fluideingang (111) verbunden ist und eine kreisförmige Verbindungsöffnung (113a) aufweist, eine zweite Kammer (114), die mit dem Fluidausgang (112) verbunden ist, und eine Ventilkugel (115) umfasst,
wobei
die erste Kammer (113) in der zweiten Kammer (114) aufgenommen ist, die zweite Kammer (114) mit der ersten Kammer (113) über die kreisförmige Verbindungsöffnung (113a) verbunden ist, der Durchmesser der Ventilkugel (115) den der kreisförmigen Verbindungsöffnung (113a) der ersten Kammer (113) übersteigt, und die Ventilkugel (115) drehbar zwischen der ersten und der zweiten Kammer (113, 114) angeordnet ist, um lösbar in die kreisförmige Verbindungsöffnung (113a) der ersten Kammer (113) eingreifen zu können und um die Verbindung zwischen der ersten und der zweiten Kammer (113, 114) zu kontrollieren;
die Strombereitstellungseinrichtung (130) elektrisch mit der Steuereinheit (120) verbunden ist; und
der thermoelektrische Halbleiterchip (140) an die zweite Kammer (114) des Containerkörpers (110) angrenzt und elektrisch mit der Strombereitstellungseinrichtung (130) verbunden ist, wobei die Steuereinheit (120) die Strombereitstellungseinrichtung (130) antreibt, um den thermoelektrischen Halbleiterchip (140) zum Heizen des in der zweiten Kammer (114) aufgenommenen Fluids mit Energie zu versorgen, wenn eine Temperatur des Fluids, welches in der zweiten Kammer (114) aufgenommen ist, geringer als eine von der Steuereinheit (120) vorgegebene Solltemperatur ist, und die Temperatur des Fluids, welches in der zweiten Kammer (114) aufgenommen ist, über den thermoelektrischen Halbleiterchip (140) dadurch gekühlt wird, dass die vom thermoelektrischen Halbleiterchip (140) erzeugte Wärme ausgetrieben wird, wenn die Temperatur des Fluids, welches in der zweiten Kammer (114) aufgenommen wird, größer ist als die von der Steuereinheit (120) vorgegebene Solltemperatur.

2. Tragbare Vorrichtung (100) zum Abgeben von kaltem und heißem Wasser nach Anspruch 1, wobei das Volumen der zweiten Kammer (114) geringer ist als das der ersten Kammer (113).

3. Tragbare Vorrichtung (100) zum Abgeben von kaltem und heißem Wasser nach Anspruch 1, weiterhin umfassend einen Temperatursensor, der mit der zweiten Kammer (114) des Containerkörpers (110) und elektrisch mit der Steuereinheit (120) verbunden ist.

4. Tragbare Vorrichtung (100) zum Abgeben von kaltem und heißem Wasser nach Anspruch 1, weiterhin umfassend ein Gebläse (170), das benachbart zum thermoelektrischen Halbleiterchip (140) angeordnet und elektrisch mit der Steuereinheit (120) verbunden ist.

5. Tragbare Vorrichtung (100) zum Abgeben von kaltem und heißem Wasser nach Anspruch 4, weiterhin umfassend einen Sockel (180), der mit dem Containerkörper (110) verbunden ist und den thermoelektrischen Halbleiterchip (140) und das Gebläse (170) umfasst.

6. Tragbare Vorrichtung (100) zum Abgeben von kaltem und heißem Wasser nach Anspruch 5, wobei der Sockel (180) mindestens eine Entlüftungsöffnung (181) aufweist, die um das Gebläse (170) angeordnet ist.

7. Tragbare Vorrichtung (100) zum Abgeben von kaltem und heißem Wasser nach Anspruch 1, weiterhin umfassend eine Anzeigetafel (160), welche elektrisch mit der Steuereinheit (120) und der Strombereitstellungseinrichtung (130) verbunden ist.

8. Tragbare Vorrichtung (100) zum Abgeben von kaltem und heißem Wasser nach Anspruch 1, weiterhin umfassend eine Bedienungsschnittstelle (160), welche elektrisch mit der Steuereinheit (120) verbunden ist und einen Gerätestromschalter (191), einen Temperaturerhöhungsschalter (192), einen Temperaturerniedrigungsschalter (193) und eine Leuchtanzeige (194) aufweist.

9. Tragbare Vorrichtung (100') zum Abgeben von kaltem und heißem Wasser, umfassend eine Steuereinheit (120), einen Containerkörper (110), eine Strombereitstellungseinrichtung (130) und einen thermoelektrischen Halbleiterchip (140), wobei
der Containerkörper (110) einen Fluideingang (111), einen Fluidausgang (112), eine erste Kammer (113), die mit dem Fluideingang (111) verbunden ist, eine zweite Kammer (114), die mit dem Fluidausgang (112) verbunden ist, und ein elektromagnetisches Ventil (115') umfasst, das zwischen der ersten und der zweiten Kammer (113, 114) angeordnet ist und elektrisch mit der Steuereinheit (120) verbunden ist, um die Verbindung zwischen der ersten und der zweiten Kammer (113, 114) zu kontrollieren, wobei
die erste Kammer (113) in der zweiten Kammer (114) aufgenommen ist, die Strombereitstellungseinrichtung (130) elektrisch mit der Steuereinheit (120) verbunden ist, und der thermoelektrische Halbleiterchip (140) an die zweite Kammer (114) des Containerkörpers (110) angrenzt und elektrisch mit der Strombereitstellungseinrichtung (130) verbunden ist, wobei die Steuereinheit (120) die Strombereitstellungseinrichtung (130) antreibt, um den thermoelektrischen Halbleiterchip (140) zum Heizen des in der zweiten Kammer (114) aufgenommenen Fluids mit Energie zu versorgen, wenn eine Temperatur des Fluids, welches in der zweiten Kammer (114) aufgenommen ist, geringer als eine von der Steuereinheit (120) vorgegebene Solltemperatur ist, und die Temperatur des Fluids, welches in der zweiten Kammer (114) aufgenommen ist, über den thermoelektrischen Halbleiterchip (140) dadurch gekühlt wird, dass die vom thermoelektrischen Halbleiterchip (140) erzeugte Wärme ausgetrieben wird, wenn die Temperatur des Fluids, welches in der zweiten Kammer (114) aufgenommen wird, größer ist als die von der Steuereinheit (120) vorgegebene Solltemperatur.

10. Tragbare Vorrichtung (100') zum Abgeben von kaltem und heißem Wasser nach Anspruch 9, wobei das Volumen der zweiten Kammer (114) geringer ist als das der ersten Kammer (113).

11. Tragbare Vorrichtung (100') zum Abgeben von kaltem und heißem Wasser nach Anspruch 9, weiterhin umfassend einen Temperatursensor, der mit der zweiten Kammer (114) des Containerkörpers (110) und elektrisch mit der Steuereinheit (120) verbunden ist.

12. Tragbare Vorrichtung (100) zum Abgeben von kaltem und heißem Wasser nach Anspruch 9, weiterhin umfassend ein Gebläse (170), das benachbart zum thermoelektrischen Halbleiterchip (140) angeordnet und elektrisch mit der Steuereinheit (120) verbunden ist.

13. Tragbare Vorrichtung (100') zum Abgeben von kaltem und heißem Wasser nach Anspruch 12, weiterhin umfassend einen Sockel (180), der mit dem Containerkörper (110) verbunden ist und den thermoelektrischen Halbleiterchip (140) und das Gebläse (170) umfasst.

14. Tragbare Vorrichtung (100') zum Abgeben von kaltem und heißem Wasser nach Anspruch 13, wobei der Sockel (180) mindestens eine Entlüftungsöffnung (181) aufweist, die um das Gebläse (170) angeordnet ist.

15. Tragbare Vorrichtung (100') zum Abgeben von kaltem und heißem Wasser nach Anspruch 9, weiterhin umfassend eine Anzeigetafel (160), welche elektrisch mit der Steuereinheit (120) und der Strombereitstellungseinrichtung (130) verbunden ist.

16. Tragbare Vorrichtung (100') zum Abgeben von kaltem und heißem Wasser nach Anspruch 9, weiterhin umfassend eine Bedienungsschnittstelle (160), welche
elektrisch mit der Steuereinheit (120) verbunden ist und einen Gerätestromschalter (191), einen Temperaturerhöhungsschalter (192), einen Temperaturerniedrigungsschalter (193) und eine Leuchtanzeige (194) aufweist.

## Revendications

1. Dispositif d'alimentation en eau froide et chaude portable (100), comprenant un corps de récipient (110), un dispositif de commande (120), un dispositif d'alimentation électrique (130) et une puce à semi-conducteur thermoélectrique (140), dans lequel :
le corps de récipient (110) comprend une entrée de fluide (111), une sortie de fluide (112), une première chambre (113) connectée à l'entrée de fluide (111) et comprenant un trou de connexion circulaire (113a), une deuxième chambre (114) connectée à la sortie de fluide (112), et une valve sphérique (115), dans lequel la première chambre (113) est reçue dans la deuxième chambre (114), la deuxième chambre (114) se connecte à la première chambre (113) par le biais du trou de connexion circulaire (113a) de la première chambre (113), le diamètre de la valve sphérique (115) dépasse celui du trou de connexion circulaire (113a) de la première chambre (113), et la valve sphérique (115) est disposée avec possibilité de rotation entre les première et deuxième chambres (113 et 114) pour pouvoir être engagée de façon libérable dans le trou de connexion circulaire (113a) de la première chambre (113) pour commander une connexion entre les première et deuxième chambres (113 et 114), le dispositif d'alimentation électrique (130) est connecté électriquement au dispositif de commande (120), et la puce à semi-conducteur thermoélectrique (140) est en appui sur la deuxième chambre (114) du corps de récipient (110) et est connectée électriquement au dispositif d'alimentation électrique (130), dans lequel le dispositif de commande (120) attaque le dispositif d'alimentation électrique (130) pour alimenter la puce à semi-conducteur thermoélectrique (140) pour chauffer le fluide reçu dans la deuxième chambre (114) lorsqu'une température d'un fluide reçu dans la deuxième chambre (114) est inférieure à une température souhaitée provenant du dispositif de commande (120), et la température du fluide reçu dans la deuxième chambre (114) est refroidie par le biais de la puce à semi-conducteur thermoélectrique (140) en évacuant de la chaleur générée à partir de la puce à semi-conducteur thermoélectrique (140) lorsque la température du fluide reçu dans la deuxième chambre (114) est supérieure à la température souhaitée provenant du dispositif de commande (120).

2. Dispositif d'alimentation en eau chaude et froide portable (100) selon la revendication 1, dans lequel le volume de la deuxième chambre (114) est inférieur à celui de la première chambre (113).

3. Dispositif d'alimentation en eau chaude et froide portable (100) selon la revendication 1, comprenant en outre un capteur de température connectée à la deuxième chambre (114) du corps de récipient (110) et connecté électriquement au dispositif de commande (120).

4. Dispositif d'alimentation en eau chaude et froide portable (100) selon la revendication 1, comprenant en outre un ventilateur (170) adjacent à la puce à semi-conducteur thermoélectrique (140) et connecté électriquement au dispositif d'alimentation électrique (130).

5. Dispositif d'alimentation en eau chaude et froide portable (100) selon la revendication 4, comprenant en outre une base (180) connectée au corps de récipient (110) et recouvrant la puce à semi-conducteur thermoélectrique (140) et le ventilateur (170).

6. Dispositif d'alimentation en eau chaude et froide portable (100) selon la revendication 5, dans lequel la base (180) comprend au moins un évent (181) disposé autour du ventilateur (170).

7. Dispositif d'alimentation en eau chaude et froide portable (100) selon la revendication 1, comprenant en outre un panneau d'affichage (160) connecté électriquement au dispositif de commande (120) et au dispositif d'alimentation électrique (130).

8. Dispositif d'alimentation en eau chaude et froide portable (100) selon la revendication 1, comprenant en outre une interface d'utilisation (190) connectée électriquement au dispositif de commande (120) et comprenant une touche de commutation d'alimentation (191), une touche d'augmentation de la température (192), une touche de diminution de la température (193), et un voyant lumineux (194).

9. Dispositif d'alimentation en eau chaude et froide portable (100'), comprenant un dispositif de commande (120), un corps de récipient (110), un dispositif d'alimentation électrique (130) et une puce à semi-conducteur thermoélectrique (140), dans lequel :
le corps de récipient (110) comprend une entrée de fluide (111), une sortie de fluide (112), une première chambre (113) connectée à l'entrée de fluide (111), une deuxième chambre (114) connectée à la sortie de fluide (112), et une vanne électromagnétique (115') disposée entre les première et deuxième chambres (113 et 114) et connectée électriquement au dispositif de commande (120) pour commander une connexion entre les première et deuxième chambres (113 et 114), dans lequel la première chambre (113) est reçue dans la deuxième chambre (114), le dispositif d'alimentation électrique (130) est connecté électriquement au dispositif de commande (120), et la puce à semi-conducteur thermoélectrique (140) en appui sur la deuxième chambre (114) du corps de récipient (110) est connectée électriquement au dispositif d'alimentation électrique (130), dans lequel le dispositif de commande (120) attaque le dispositif d'alimentation électrique (130) pour alimenter la puce à semi-conducteur thermoélectrique (140) pour chauffer le fluide reçu dans la deuxième chambre (114) lorsqu'une température d'un fluide reçu dans la deuxième chambre (114) est inférieure à une température souhaitée provenant du dispositif de commande (120), et la température du fluide reçu dans la deuxième chambre (114) est refroidie par le biais de la puce à semi-conducteur thermoélectrique (140) en évacuant de la chaleur générée à partir de la puce à semi-conducteur thermoélectrique (140) lorsque la température du fluide reçu dans la deuxième chambre (114) est supérieure à la température souhaitée provenant du dispositif de commande (120).

10. Dispositif d'alimentation en eau chaude et froide portable (100') selon la revendication 9, dans lequel le volume de la deuxième chambre (114) est inférieur à celui de la première chambre (113).

11. Dispositif d'alimentation en eau chaude et froide portable (100') selon la revendication 9, comprenant en outre un capteur de température connecté à la deuxième chambre (114) du corps de récipient (110) et connecté électriquement au dispositif de commande (120).

12. Dispositif d'alimentation en eau chaude et froide portable (100') selon la revendication 9, comprenant en outre un ventilateur (170) adjacent à la puce à semi-conducteur thermoélectrique (140) et connecté électriquement au dispositif d'alimentation électrique (130).

13. Dispositif d'alimentation en eau chaude et froide portable (100') selon la revendication 12, comprenant en outre une base (180) connectée au corps de récipient (110) et recouvrant la puce à semi-conducteur thermoélectrique (140) et le ventilateur (170).

14. Dispositif d'alimentation en eau chaude et froide portable (100') selon la revendication 13, dans lequel la base (180) comprend au moins un évent (181) disposé autour du ventilateur (170).

15. Dispositif d'alimentation en eau chaude et froide portable (100') selon la revendication 9, comprenant en outre un panneau d'affichage (160) connecté électriquement au dispositif de commande (120) et au dispositif d'alimentation électrique (130).

16. Dispositif d'alimentation en eau chaude et froide portable (100') selon la revendication 9, comprenant en outre une interface d'utilisation (190) connectée électriquement au dispositif de commande (120) et comprenant une touche de commutation d'alimentation (191), une touche d'augmentation de la température (192), une touche de diminution de la température (193), et un voyant lumineux (194).
